# EUROPEAN PATENT SPECIFICATION

(11) **EP 2 019 153 B1**
(45) Date of publication and mention of the grant of the patent: **22.04.2015**
(21) Application number: 07742791.2
(22) Date of filing: 02.05.2007
(51) Int. Cl.: C23C 16/455

(54) **GAS SUPPLY PIPE FOR PLASMA TREATMENT**
GASZUFUHRROHR FÜR PLASMABEHANDLUNG
TUYAU D'ALIMENTATION EN GAZ POUR TRAITEMENT AU PLASMA

(30) Priority: 17.05.2006 JP 2006137896
(43) Date of publication of application: 28.01.2009
(73) Proprietor: Toyo Seikan Kaisha, Ltd., Shinagawa-ku Tokyo 141-8640 (JP)
(72) Inventor: KOISHI, Ryousuke, Kokohama-shi Kanagawa 230-0001 (JP); FUJIMOTO, Hiroshi, Yokohama-shi Kanagawa 230-0001 (JP)
(74) Representative: Liebetanz, Michael
(86) International application number: PCT/JP2007/059356
(87) International publication number: WO 2007/132676

(56) References cited:
- EP-A1- 0 863 228
- EP-A1- 1 602 748
- WO-A1-2004/081254
- JP-A- 1 188 678
- JP-A- 6 285 652
- JP-A- 01 188 678
- JP-A- 2004 002 928
- JP-A- 2004 002 928
- JP-A- 2005 200 724
- JP-A- 2005 200 724

## Description

### TECHNICAL FIELD

The invention relates to a gas supply pipe for plasma treatment to be used in forming a deposited film by the plasma CVD method on the inner surface of a container such as a plastic bottle.

### BACKGROUND

The chemical vapor deposition method (CVD) is a technique in which a reaction product is allowed to be deposited in the form of a film on the substrate surface due to the growth of a vapor phase in a high temperature atmosphere by using a raw material gas which does not react at normal temperature, and is used widely for semiconductor production and surface modification of a metal or ceramics. Recently, this technology is being used for the surface modification of a plastic bottle, in particular, for the improvement of gas barrier properties.

Plasma CVD is a technology of growing a thin film by using plasma. Basically, it comprises discharging a gas containing a raw material gas under reduced pressure by electric energy due to a high electric field. A substance generated by dissociation and bonding is subjected to a chemical reaction in a vapor phase or on an object to be treated, thereby causing the substance to be accumulated on the object to be treated.

Plasma condition is realized by glow discharge or by other methods. According to the type of glow discharge, various plasma CVD methods are known. Examples include the plasma CVD method by the microwave glow discharge and the plasma CVD method by the high-frequency glow discharge.

In either the microwave plasma CVD method or the high-frequency plasma CVD method, a deposited film is formed on the inner surface of a container as follows. A container is held in a plasma treatment chamber. A gas supply pipe for supplying a reactive gas (a gas for plasma treatment) is inserted in the inside of the container. The pressure inside of the container is reduced at least to a prescribed degree of vacuum. While supplying a reactive gas to the inside of the apparatus, microwave or high-frequency glow discharge is generated within the container. As a result, a deposited film is formed on the inner surface of the container.

Therefore, to form a deposited film with a uniform thickness on the inner surface of the container, it is required to supply a reactive gas uniformly within the container. As the gas supply pipe for this purpose, a porous pipe in which the pores of a porous body serve as gas blow-off holes or a porous pipe in which gas blow-off holes are formed on the wall of a metal pipe or the like by boring or other methods is known.

In recent years, a gas supply pipe provided with a blow-off amount adjusting member at the end portion of a gas supply pipe main body which enables more uniform gas supply (see Patent Document 1, for example) or a gas supply pipe provided with a non-metal tube (a supply channel extension member) at the end portion of a porous metal tube (a supply pipe main body) which can extend the gas supply channel without being affected by the wavelength of a microwave is proposed (see Patent Document 2, for example).
Patent Document 1: JP-A-2004-277757
Patent Document 2: JP-A-2005-68471

Furthermore EP 1 602 748 and JP 2005 200724 are known from prior art. Both of which are directed onto microwave plasma processing devices.

### DISCLOSURE OF THE INVENTION

### Problems to be Solved by the Invention

However, in forming a deposited film on the inner surface of the container by using the above-mentioned plasma CVD methods, a deposited film is formed not only on the inner surface of the container but also on the outer surface of the gas supply pipe. If the deposited film formed on the outer surface of the gas supply pipe is thin enough not to cause clogging of the gas blow-off hole of the gas supply pipe, it does not affect significantly film formation. However, if the deposited film is peeled off from the gas supply pipe, the peeled film not only may adhere as a foreign matter to the inner surface of the container on which a deposited film is to be formed but also may drop to the nozzle-sealed surface, causing the degree of vacuum inside of the plasma treatment chamber to lower.

The invention has been made in view of the above-mentioned circumstances, and the object thereof is to provide a gas supply pipe for plasma treatment which can effectively suppress peeling off of a deposited film formed on the outer surface of the gas supply pipe and can prevent as much as possible adhesion of a peeled deposited film to the inner surface of a container or to the nozzle-sealed surface.

### Means for Solving the Problem

In order to attain the above-mentioned object, the gas supply pipe for plasma treatment of the invention is inserted into a container held in a plasma treatment chamber to form a deposited film on the inner surface of the container by the supply of a gas for plasma treatment to the inside of the container, wherein a supply pipe-forming member constituting the portion or whole of the gas supply pipe has a thermal expansion coefficient of 10 × 10⁻⁶/°C or less.

Due to such a configuration, the possibility that a deposited film formed on the outer surface of the gas supply pipe is peeled off by thermal expansion or thermal shrinkage can be decreased. That is, during the film formation, the gas supply pipe is thermally expanded with an increase in temperature in the treatment chamber. After the film formation, the gas supply pipe is thermally shrunk with a decrease in temperature due to the opening of the chamber. As a result, shift in position occurs between the gas supply pipe and a deposited film formed on the outer surface thereof due to thermal expansion or thermal shrinkage. As a result, a deposited film tends to be easily peeled off. However, by allowing the gas supply pipe (part or whole) to have a thermal expansion coefficient of 10 × 10⁻⁶/°C or less, peeling off of a deposited film can be effectively prevented. Due to such a configuration, the disadvantage that a deposited film which has been peeled off from the gas supply pipe may adhere as a foreign matter to the inner surface of the container or may drop to the nozzle-sealed surface, causing the degree of vacuum in the inside of the plasma treatment chamber to lower, can be eliminated.

In the gas supply pipe for plasma treatment of the invention, the above-mentioned supply pipe-forming member is composed of titanium or ceramics.

Due to such a configuration, a deposited film composed of silicon oxide can be formed on the inner surface of the container, while effectively suppressing the peeling off of a deposited film formed on the outer surface of the gas supply pipe.

In the gas supply pipe for plasma treatment of the invention, the supply pipe-forming member is a supply pipe main body having gas blow-off holes.

Due to such a configuration, peeling off of a deposited film formed on the outer surface of the supply pipe main body can be effectively suppressed.

In the gas supply pipe for plasma treatment of the invention, the supply pipe-forming member is a blow-off amount-adjusting member provided at the end portion of the supply pipe main body.

Due to such a configuration, peeling off of a deposited film formed on the outer surface of the blow-off amount adjusting member can be effectively prevented.

In the gas supply pipe for plasma treatment of the invention, the supply pipe-forming member is a connection member which connects the supply pipe main body formed of a metal tube with a supply channel-extension member formed of a non-metal tube.

Due to such a configuration, peeling off of a deposited film formed on the outer surface of the connection member can be effectively prevented.

### Advantageous Effects of the Invention

As mentioned hereinabove, according to the invention, since the part or whole of the gas supply pipe is formed of a supply pipe-forming member having a thermal expansion coefficient of 10 × 10⁻⁶/°C or less, in forming a deposited film on the inner surface of a container by the plasma CVD method, the possibility that a deposited film formed on the outer surface of the gas supply pipe may peel off by thermal expansion or thermal shrinkage of the gas supply pipe can be reduced. As a result, the disadvantage can be eliminated in which a deposited film has been peeled off from the gas supply pipe adheres as a foreign matter to the inner surface of a container, or drops to a nozzle-sealed surface, lowering the degree of vacuum inside the plasma treatment chamber.

### BRIEF DESCRIPTION OF THE DRAWINGS

FIG. 1 is a schematic cross-sectional view of a plasma treatment chamber of a gas supply pipe for plasma treatment;
FIG. 2 is a cross-sectional view of the gas supply pipe for plasma treatment;
FIG. 3 is a cross-sectional view of the gas supply pipe for plasma treatment according; and
FIG. 4 is a cross-sectional view of the gas supply pipe for plasma treatment according to the invention.

### Explanation of Symbols

- 1.: Plasma treatment chamber
- 2.: Chamber
- 3.: Container
- 4.: Gas supply pipe
- 5.: Supply pipe main body
- 5a.: Gas supply channel
- 5b.: Gas blow-off hole
- 6.: Gas supply pipe
- 7.: Supply pipe main body
- 8.: Blow-off amount adjusting member
- 8a.: Blow-off amount adjusting hole
- 9.: Gas supply pipe
- 10.: Supply pipe main body
- 11.: Supply channel extension member
- 12.: Connection member
- 12a.: Tube coupling portion
- 12b.: Tube coupling portion

### BEST MODE FOR CARRYING OUT THE INVENTION

The embodiments of the invention will be explained below with reference to the drawings.

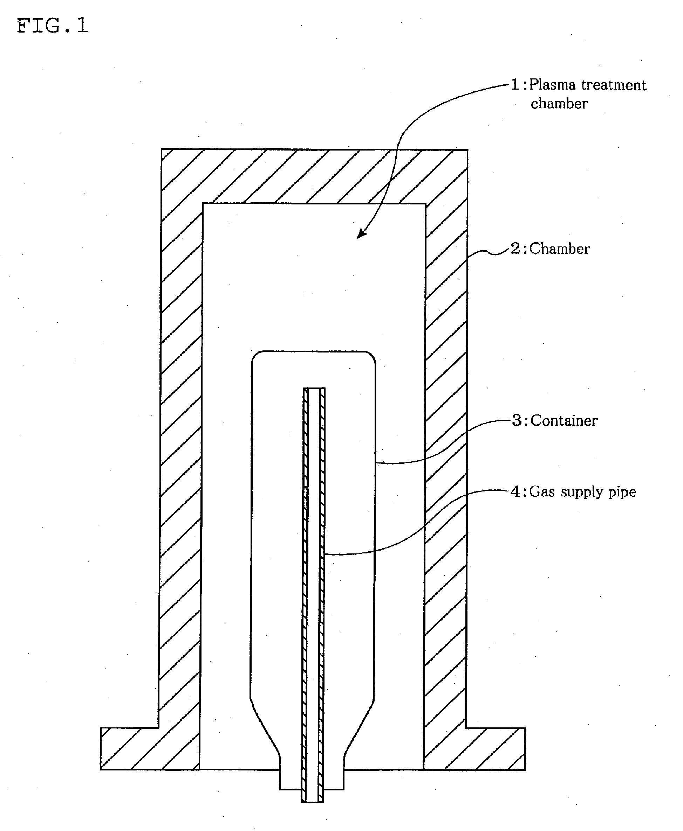

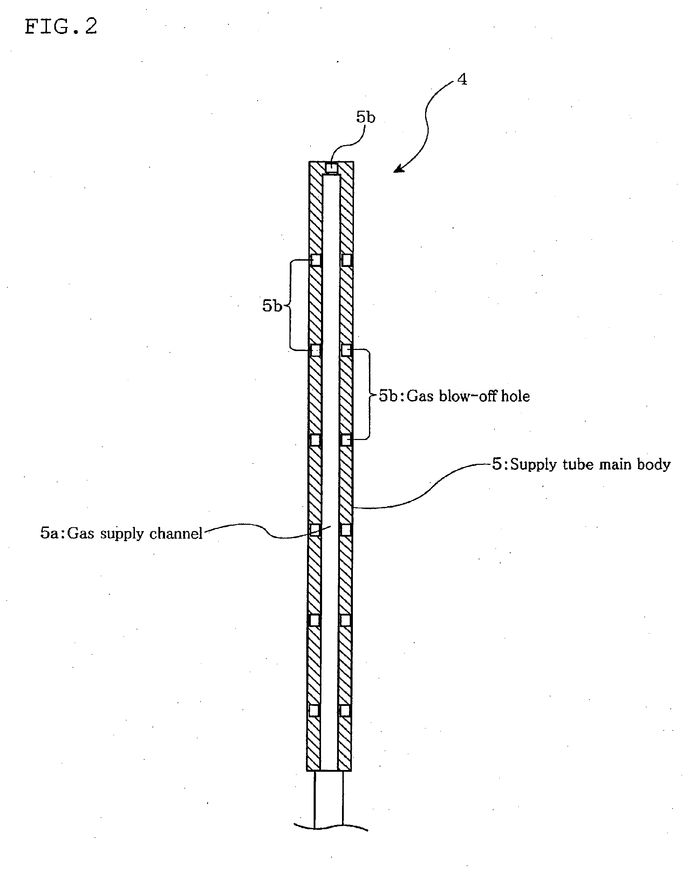

First, the gas supply pipe for plasma treatment will be explained with reference to FIGs. 1 and 2.

FIG. 1 is a schematic cross-sectional view of a plasma treatment chamber where the gas supply pipe for plasma treatment is used. FIG. 2 is a cross-sectional view of the gas supply pipe for plasma treatment.

The process for forming a deposited film on the inner surface of the container by plasma treatment is explained below, using microwave CVD as an example. As shown in FIG. 1, a plasma treatment chamber 1 is formed of a metal chamber 2 in order to confine an electric wave (microwave) to be introduced. In the plasma treatment chamber 1, a container 3 to be treated (a plastic bottle, for example) is held in an upside down manner. The gas supply pipe 4 is inserted in this container 3.

In the plasma treatment, the inside of the container 3 is maintained in the vacuum state by a predetermined exhaust system. At the same time, to prevent the container 3 from being deformed by external pressure, the pressure inside of the plasma treatment chamber 1 (outside of the container 3) is reduced. In this case, the pressure inside of the container 3 is significantly reduced to allow glow discharge to occur by the introduction of a microwave. On the other hand, the pressure inside of the plasma treatment chamber 1 is not highly reduced in order not to allow glow discharge to occur even though a microwave is being introduced.

After keeping the inside and outside of the container 3 at a predetermined reduced pressure as mentioned above, a reactive gas is supplied to the inside of the container 3 by means of a gas supply pipe 4. At the same time, a microwave is introduced into a plasma treatment chamber 1 to cause plasma to be generated by glow discharge. The temperature of the electrons in the plasma is several tens of thousands °K, which is higher by about double digits as compared to the temperature of the gas particles, which are several hundreds °K. This means that the plasma is thermally in the non-equilibrium state. Therefore, effective plasma treatment can be performed for a low-temperature plastic substrate.

The reactive gas is reacted by the above plasma, causing a deposited film to accumulate on the inner surface of the container 3. After forming a deposited film with a predetermined thickness on the inner surface of the container 3, the supply of reactive gas and the introduction of microwaves are stopped, and cooled air is gradually introduced into the inside of the plasma treatment chamber 1 or the container 3, thereby allowing the pressure of the inside and outside of the container 3 to be an atmospheric pressure. The plasma-treated container 3 is taken out of the plasma treatment chamber 1.

In this embodiment, as the container 3 to be treated, a bottle made of plastics can be used.

Examples of usable plastics include known thermoplastic resins. Specific examples include a polyolefin such as low-density polyethylene, high-density polyethylene, polypropylene, poly-1-butene and poly-4-methyl-1-pentene; a random copolymer or a block copolymer composed of an α-olefin such as ethylene, propylene, 1-butene and 4-methyl-1-pentene; an ethylene-vinyl compound copolymer such as an ethylene-vinyl acetate copolymer, an ethylene-vinyl alcohol copolymer and an ethylene-vinyl chloride copolymer; styrene resins such as polystyrene, an acrylonitrile-styrene copolymer, ABS and an α-methylene-styrene copolymer; polyvinyl compounds such as polyvinyl chloride, polyvinylidene chloride, a vinyl chloride-vinylidene chloride copolymer, polymethyl acrylate and polymethyl methacrylate; polyamides such as nylon6, nylon6-6, nylon6-10, nylon11 and nylon12; thermoplastic polyesters such as polyethylene terephthalate, polybutylene terephthalate and polyethylene naphthalate; polycarbonate and polyphenylene oxide. These resins are used singly or in combination of two or more.

There are no specific restrictions on the shape of the container 3. The container 3 may be in an arbitrary shape, such as a bottle, a cup and a tube.

As the reactive gas, an appropriate gas may be selected according to the type of a deposited film to be formed on the inner surface of the container 3. For example, it is preferable to use a reaction gas obtained by allowing a compound containing an atom, a molecule or an ion which forms a thin film to be in a vapor phase, followed by mixing with an appropriate carrier gas. In order to form a carbon film or a carbide film, hydrocarbons such as methane, ethane, ethylene and acetylene are used. In order to form a silicon film, silicon tetrachloride, silane, organic silane compounds, organic siloxane compounds, or the like may be used. It is also possible to use halides (chlorides) of titanium, zirconium, tin, aluminum, yttrium, molybdenum, tungsten, gallium, tantalum, niobium, iron, nickel, chromium, boron and the like or organic metal compounds. Furthermore, an oxide gas is used to form an oxygen film, and a nitrogen gas or an ammonium gas is used to form a nitride film. Two or more of these gases may be used in combination according to the chemical composition of a thin film to be formed. As the carrier gas, argon, neon, helium, xenon and hydrogen are suitable.

The gas supply pipe 4 which is used in the above-mentioned plasma treatment, is composed of a supply pipe main body 5 having a gas supply channel 5a and a gas blow-off hole 5b, as shown in FIG. 2.

That is, in the inside of the supply pipe main body 5, the gas supply channel 5a extending in the axial direction from the base portion to the end portion is formed. The base portion of this gas supply channel 5a is open such that it can be connected to an induction system for introducing a prescribed reactive gas.

The gas supply channel 5a may extend with a fixed diameter to the end wall portion, and may penetrate the end wall. However, the portion which penetrates the end wall may preferably have a diameter as small as that of the gas blow-off hole 5b. If the end wall is closed, the gas supply to the bottom of the container 3 may be insufficient. If the diameter of the end wall portion of the gas supply channel 5a is larger than that of the gas blow-off hole 5b, the amount of the gas blown off from the end wall portion becomes larger than the amount of the gas blown off from other portions, resulting in the formation of a deposited film with a non-uniform thickness.

On the wall surface of the supply pipe main body 5, a plurality of gas blow-off holes 5b are formed by a method such as laser machining and punching. These gas blow-off holes 5b are formed almost uniformly over the entire surface of the outer wall of the supply pipe main body 5, with appropriate intervals in the axial and circumferential directions.

It is preferred that the diameter of the gas blow-off holes 5b be 0.2 mm or more. That is, by allowing the diameter of the gas blow-off hole 5b to be large, clogging of the gas blow-off hole 5b may effectively be prevented. If this diameter is unnecessarily large, the gas blow-off amount may tend to be non-uniform. Therefore, it is preferred that this diameter be 3 mm or less.

The length of the gas supply pipe 4 may be a length which covers a range from the neck portion to the proximity of the bottom portion of the container 3. If the entire area of the gas supply pipe 4 is formed of the gas supply pipe main body 5 consisting of a metal tube, the length thereof may preferably be one-half of a wavelength of a microwave used as a reference which is determined by the size of the plasma treatment room 1 or by other factors. This length allows the electric field intensity distribution along the axial direction of the container 3 to be stable, preventing un-uniform thickness of a deposited film.

The gas supply pipe 4 is characterized in that a supply pipe-forming member constituting the part or whole of the gas supply pipe is composed of a material having a thermal expansion coefficient of 10 × 10⁻⁶/°C or less. For example, if a deposited film composed of silicon oxide is formed on the inner surface of the container 3 by using the gas supply pipe 4 of this embodiment, as a preferred material of the supply pipe main body 5, titanium (Ti) having a thermal expansion coefficient of 8.6 × 10⁻⁶/°C may be selected.

By using this material, the possibility that a deposited film formed on the outer surface of the gas supply pipe 4 is peeled off by thermal expansion or thermal shrinkage may be reduced.

The thermal expansion coefficient of stainless steel which has conventionally been used widely as the material of the gas supply pipe 4 is 15 to 17 × 10⁻⁶/°C. During film formation, the gas supply pipe 4 is thermally expanded with an increase in temperature in the inside of the plasma treatment chamber 1. After film formation, the gas supply pipe 4 is thermally shrunk with a decrease in temperature, due to the opening of the chamber 2. As a result, shift in position caused by thermal expansion or thermal shrinkage occurs between the gas supply pipe 4 and the deposited film formed on the outer surface thereof, causing a deposited film to be easily peeled off.

However, in this embodiment, since the supply pipe main body 5 constituting the entire gas supply pipe 4 has a thermal expansion coefficient of 10 × 10⁻⁶/°C or less, peeling off of the deposited film caused by thermal expansion or thermal shrinkage of the gas supply pipe 4 can be effectively prevented. As a result, the disadvantage that a deposited film which has been peeled off from the gas supply pipe 4 may adhere as a foreign matter to the inner surface of the container 3 or may drop to the nozzle-sealed surface to lower the degree of vacuum in the plasma treatment chamber 1 can be eliminated.

In the above-mentioned embodiment, the gas supply pipe 4 for plasma treatment is inserted in a container 3 held in a plasma treatment chamber 1 to form a deposited film on the inner surface of the container with the supply of a gas for plasma treatment to the inside of the container 3, wherein a supply pipe main body 5 constituting the entire gas supply pipe is formed of a material having a thermal expansion coefficient of 10 × 10⁻⁶/°C or less. Due to such a configuration, the possibility that a deposited film formed on the outer surface of the gas supply pipe 4 may be peeled off by thermal expansion or thermal shrinkage of the gas supply pipe 4 can be reduced. As a result, the disadvantage that a deposited film which has been peeled off from the gas supply pipe 4 may adhere as a foreign matter to the inner surface of the container 3 or may drop to the nozzle-sealed surface to lower the degree of vacuum in the plasma treatment chamber 1 can be eliminated.

In this embodiment, by forming the supply pipe main body 5 of the gas supply pipe 4 from titanium having a thermal expansion coefficient of 8. 6 × 10⁻⁶/°C, a deposited film composed of silicon oxide can be formed on the inner surface of the container 3, while effectively suppressing the peeling off of a deposited film formed on the outer surface of the gas supply pipe 4.

For example, in the above embodiment, titanium having a thermal expansion coefficient of 8.6 × 10⁻⁶/°C is used as a material of the supply pipe main body on the assumption that a silicon oxide film is formed. However, the material is not limited to titanium insofar as it has a thermal expansion coefficient of 10 × 10⁻⁶/°C or less, and any preferable material may be selected appropriately according to the thermal expansion coefficient of a deposited film. For example, ceramics (alumina) with a thermal expansion coefficient of 7.0 × 10⁻⁶/°C or ceramics (machinable) with a thermal expansion coefficient of 8.5 × 10⁻⁶/°C can be selected.

In the meantime, machinable ceramics is a generic name of composite ceramics composed mainly of glass material with improved processability.

In the above example, an explanation was made taking as an example plasma treatment by microwave glow discharge. However, the above-mentioned gas supply pipe can be applied to plasma treatment by high-frequency glow discharge. High-frequency plasma treatment is basically the same as microwave plasma treatment except that a high frequency is caused to generate using a high-frequency external electrode in the proximity of the outer surface of the container and a ground electrode in the inside of the container, and other minor conditions such as the degree of vacuum in the inside of the container. Therefore, by using the gas supply pipe of the invention, peeling off of a deposited film formed on the outer surface of the gas supply pipe can be effectively suppressed.

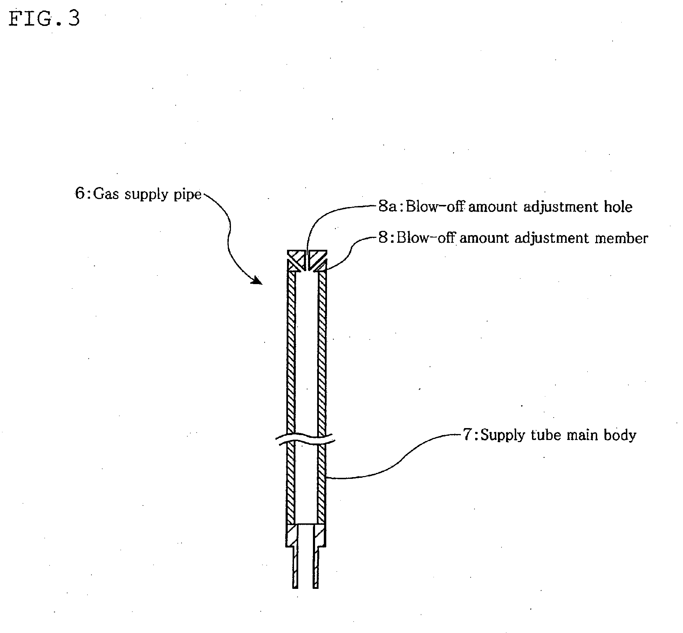

The gas supply pipe is explained with reference to FIG. 3.

FIG. 3 is a cross-sectional view of the gas supply pipe for plasma treatment.

As shown in FIG. 3, the gas supply pipe 6 differs from the gas supply pipe of the first embodiment in that a blow-off amount adjusting member 8 is provided at the end portion side of the supply pipe main body 7. The blow-off amount adjusting member 8 is a member which adjusts the distribution of the amount of gas blown off in the longitudinal direction of the gas supply pipe 6. By changing the opening of the blow-off amount adjusting hole 8a, the above-mentioned distribution can be adjusted. For example, in order to increase the gas blow-off amount on the end portion side of the gas supply pipe 6, the blow-off amount adjusting member 8 with a large opening is used. In order to decrease the gas blow-off amount on the end portion side of the gas supply pipe 6, the blow-off amount adjusting member 8 with a small opening is used.

The invention can be advantageously used in this gas supply pipe 6. When a deposited film composed of silicon oxide is formed on the inner surface of the container 3 using the gas supply tube 6, as the preferred material of the blow-off amount adjusting member 8, a material having a thermal expansion coefficient of 10 × 10⁻⁶/°C or less, for example, titanium (thermal expansion coefficient: 8.6 × 10⁻⁶/°C) can be selected. By using this material, peeling off of a deposited film formed on the outer surface of the blow-off amount adjusting member 8 can be effectively prevented.

If the supply pipe main body 7 is composed of a porous body (a sintered stainless pipe, for example), peeling off of a deposited film can be prevented. Therefore, in this embodiment, the supply pipe main body 7 is formed of a porous body and the blow-off amount adjusting member 8 is formed of a material having a thermal expansion coefficient of 10 × 10⁻⁶/°C or less.

Here, not only the supply pipe main body 7, but also the blow-off amount adjusting member 8 may be formed of a porous body. However, it is difficult to produce the blow-off amount adjusting member 8 formed of a porous body. For this reason, it is preferred that the blow-off amount adjusting member 8 be formed of a material having a thermal expansion coefficient of 10 × 10⁻⁶/°C or less.

In this embodiment, as for the material of both the supply pipe main body 7 and the blow-off amount adjusting member 8, a material having a thermal expansion coefficient of 10 × 10⁻⁶/°C or less can be selected. By this selection, in the entire area of the gas supply pipe 6, peeling off of a deposited film caused by thermal expansion or thermal shrinkage can be effectively prevented.

As the material having a thermal expansion coefficient of 10 × 10⁻⁶/°C or less, other than titanium, ceramics (alumina) with a thermal expansion coefficient of 7.0 × 10⁻⁶/°C or ceramics (machinable) with a thermal expansion coefficient of 8.5 × 10⁻⁶/°C can be selected.

Although a porous material is effective to prevent peeling, pores thereof are gradually clogged. Therefore, it is preferred that the supply pipe main body 7 be provided with gas blow-off holes as in the case of the gas supply pipe 4 in the first embodiment.

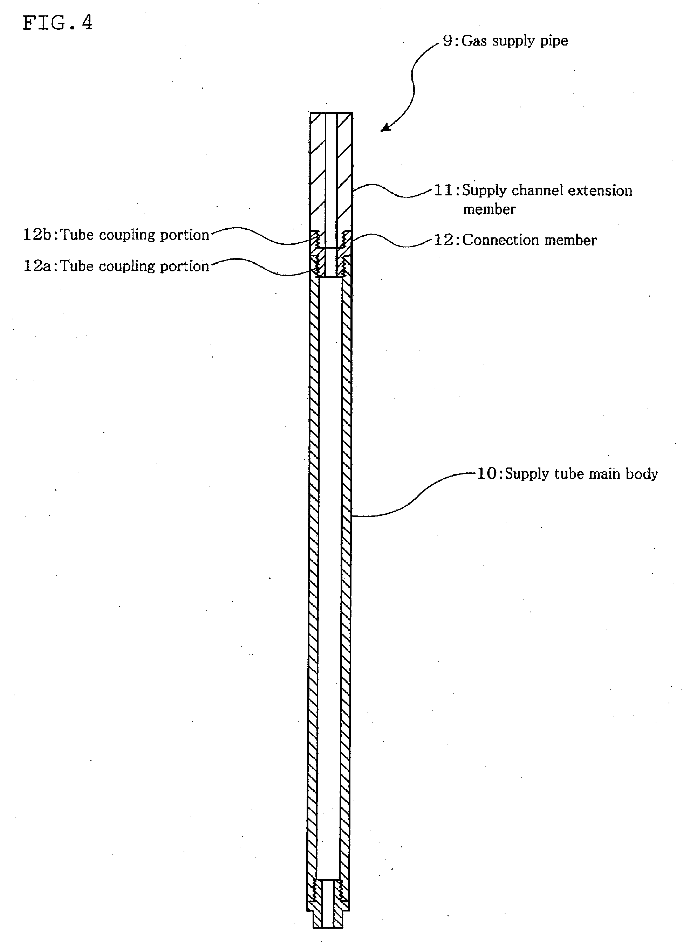

The gas supply pipe according to the invention is explained with reference to FIG. 4.

FIG. 4 is a cross-sectional view of the gas supply pipe 9 for plasma treatment according to the invention.

As shown in FIG. 4, the gas supply pipe differs from the gas supply pipe of the above-mentioned embodiment in that it is formed of the supply pipe main body 10 composed of a metal tube (a porous stainless tube, for example), a supply channel extension member 11 composed of a non-metal tube (a fluororesin tube, for example) and a connection member 12 for connecting these members. The supply channel extension member 11 is provided in order to increase the length of the gas supply channel without changing the length of the metal portion of the gas supply tube 9. Due to such a configuration, the length of the metal portion of the gas supply pipe 9 is set to one-half of the wavelength of a microwave. As a result, the electric field intensity distribution along the axial direction of the container 3 is stabilized, and the gas supply channel is extended to the vicinity of the bottom portion of the container 3, thereby effectively preventing unevenness in the thickness of a deposited film.

The connection member 12 is a short tubular element (about 12 to 15 mm in length including a tube coupling portion 12a) having tube coupling portions 12a and 12b at both ends thereof. The connection member 12 of this embodiment has threaded tube coupling portions 12a and 12b. By screwing one of the tube coupling portions 12a into the end portion of the supply pipe main body 10, and screwing the base portion of the supply channel extension member 11 into the other tube coupling portion 12b, the supply pipe main body 10 and the supply pipe extension element 11 are integrally connected.

The invention is applied to this gas supply pipe 9. For example, in forming a deposited film composed of silicon oxide on the inner surface of the container 3 using the gas supply tube 9, as the material of the preferred connection member 12, a material having a thermal expansion coefficient of 10 × 10⁻⁶/°C or less, for example, titanium (thermal expansion coefficient: 8.6 × 10⁻⁶/°C) can be selected. Due to such a configuration, peeling off of a deposited film formed on the outer surface of the connection member 12 can be effectively prevented.

As the preferred material for the supply channel extension member 11, a material having a thermal expansion coefficient of 10 × 10⁻⁶/°C or less, ceramics (having a thermal expansion coefficient of 7.0 × 10⁻⁶/°C in the case of alumina), for example, can be selected. Due to such a configuration, peeling off of a deposited film formed on the outer surface of the supply channel extension member 11 can be effectively prevented.

If the supply pipe main body 10 is composed of a porous body (a sintered stainless steel pipe, for example), peeling off of a deposited film can be prevented. Therefore, in this embodiment, the supply pipe main body 10 is formed of a porous body and the supply channel extension member 11 and the connection member 12 are formed of a material having a thermal expansion coefficient of 10 × 10⁻⁶/°C or less.

Here, not only the supply pipe main body 10 but also the supply channel extension member 11 and the connection member 12 may be formed of a porous body. However, it is difficult to form the supply channel extension member 11 or the connection member 12 from a porous body. For this reason, it is preferred that the supply channel extension member 11 and the connection member 12 be formed of a material having a thermal expansion coefficient of 10 × 10⁻⁶/°C or less.

As the material for each of the supply pipe main body 10, the supply channel extension member 11 and the connection member 12, a material having a thermal expansion coefficient of 10 × 10⁻⁶/°C or less can be selected.

As for the material having a thermal expansion coefficient of 10 × 10⁻⁶/°C or less, other than titanium, ceramics (alumina) with a thermal expansion coefficient of 7.0 × 10⁻⁶/°C, ceramics (machinable) with a thermal expansion coefficient of 8.5 × 10⁻⁶/°C or the like may be selected.

It is desired that the supply pipe main body 10 be provided with gas blow-off holes as in the case of the gas supply pipe 4 in the first embodiment.

### INDUSTRIAL APPLICABILITY

The invention can be applied to a gas supply pipe for plasma treatment which is inserted in a container held in a plasma treatment chamber to form a deposited film on the inner surface of the container by the supply of a gas for plasma treatment to the inside of the container. In particular, the invention can preferably be applied to a gas supply pipe for plasma treatment which is used for forming a deposited film by the plasma CVD method on the inner surface of a container such as a plastic bottle.

## Claims

1. A gas supply pipe for plasma treatment which is inserted in a container held in a plasma treatment chamber to form a deposited film on the inner surface of the container by the supply of a gas for plasma treatment to the inside of the container, wherein a supply pipe-forming member constituting the part or whole of the gas supply pipe has a thermal expansion coefficient of 10 x 10⁻⁶/ °C or less, **characterized in that** the supply pipe-forming member is a connection member (12) which connects a supply pipe main body (10) and a supply channel extension member (11), wherein the supply pipe main body (10) is formed of a metal tube and the supply channel extension member (11) is formed of a non-metal tube.

2. The gas supply pipe for plasma treatment according to claim 1, wherein the supply pipe-forming member is composed of titanium or ceramics.

3. The gas supply pipe for plasma treatment according to claim 1 or 2, wherein the supply pipe main body having gas blow-off holes.

4. The gas supply pipe for plasma treatment according to any of the claims 1 to 3, wherein the supply pipe main body is formed of a porous stainless tube.

5. The gas supply pipe for plasma treatment according to any of the claims 1 to 4, wherein the connection member (12), the supply pipe main body (10) and the supply channel extension member (11) have a thermal expansion coefficient of 10 x 10 ⁻⁶/ °C or less.

6. The gas supply pipe for plasma treatment according to claim 5, wherein the supply channel extension member (11) is composed of ceramics having a thermal expansion coefficient of 7.0 x 10⁻⁶/ °C or less or a fluororesin.

7. The gas supply pipe for plasma treatment according to any of the claims 1 to 6, wherein the length of the metal portion of the gas supply pipe for plasma treatment is set to one-half of the wavelength of a microwave and the gas supply channel is extended to the vicinity of the bottom portion of the container by connecting the supply channel extension member (11) to the supply pipe main body (10) through the connection member (12).

## Patentansprüche

1. Eine Gaszufuhrleitung für Plasmabehandlung, welche in einen in einer Plasmabehandlungskammer gehalten Behälter eingeführt ist, um eine abgelagerte Schicht auf der inneren Oberfläche des Behälters zu bilden, indem ein Gas für die Plasmabehandlung dem Inneren des Behälters zugeführt wird, wobei ein zufuhrleitungsförmiges Element, welches einen Teil der Gaszufuhrleitung oder die gesamte Gaszufuhrleitung bildet, einen Wärmeausdehnungskoeffizient von 10 x 10⁻⁶/°C oder weniger aufweist, **dadurch gekennzeichnet, dass** das zufuhrleitungsförmige Element ein Verbindungselement (12) ist, welches einen Zufuhrleitungs-Hauptkörper (10) und ein Verlängerungselement (11) des Zuführkanals miteinander verbindet, wobei der Zufuhrleitungs-Hauptkörper (10) aus einem Metallrohr geformt ist und das Verlängerungselement (11) des Zuführkanals aus einem nicht-metallischen Rohr geformt ist.

2. Die Gaszufuhrleitung für Plasmabehandlung nach Anspruch 1, wobei das zufuhrleitungsförmige Element aus Titan oder Keramik ausgebildet ist.

3. Die Gaszufuhrleitung für Plasmabehandlung nach Anspruch 1 oder 2, wobei der Zufuhrleitungs-Hauptkörper Gasablassöffnungen aufweist.

4. Die Gaszufuhrleitung für Plasmabehandlung nach einem der Ansprüche 1 bis 3, wobei der Zufuhrleitungs-Hauptkörper aus einem porösen rostbeständigen Rohr geformt ist.

5. Die Gaszufuhrleitung für Plasmabehandlung nach einem der Ansprüche 1 bis 4, wobei das Verbindungselement (12), der Zufuhrleitungs-Hauptkörper (10) und das Verlängerungselement (11) des Zuführkanals einen Wärmeausdehnungskoeffizienten von 10 x 10⁻⁶/°C oder weniger aufweisen.

6. Die Gaszufuhrleitung für Plasmabehandlung gemäss Anspruch 5, wobei das Verlängerungselement (11) des Zufuhrkanals aus Keramik gebildet ist und einen Wärmeausdehnungskoeffizienten von 7 x 10⁻⁶/°C oder weniger oder einen Fluorokunststoff aufweist.

7. Die Gaszufuhrleitung für Plasmabehandlung gemäss einem der Ansprüche 1 bis 6, wobei die Länge des Metallabschnittes der Gaszufuhrleitung für Plasmabehandlung auf eine Hälfte der Wellenlänge einer Mikrowelle eingestellt ist, und wobei der Gaszufuhrkanal in die Umgebung des unteren Bereichs des Behälters verlängert ist, indem das Verlängerungselement (11) des Zufuhrkanals durch das Verbindungselement (12) mit dem Zufuhrleitungs-Hauptkörper (10) verbunden wird.

## Revendications

1. Tuyau d'alimentation en gaz pour un traitement au plasma qui est inséré dans un récipient maintenu dans une chambre de traitement au plasma pour former un film déposé sur la surface intérieure du récipient par la fourniture d'un gaz pour le traitement au plasma sur le côté intérieur du récipient, dans lequel un élément de formation de tuyau d'alimentation qui constitue une partie ou la totalité du tuyau d'alimentation en gaz présente un coefficient de dilatation thermique de 10 x 10⁻⁶/°C, ou moins, **caractérisé en ce que** l'élément de formation de tuyau d'alimentation est un élément de connexion (12) qui connecte un corps principal de tuyau d'alimentation (10) et un élément d'extension de canal d'alimentation (11), dans lequel le corps principal de tuyau d'alimentation (10) est constitué d'un tube de métal, et l'élément d'extension de canal d'alimentation (11) est constitué d'un tube non métallique.

2. Tuyau d'alimentation en gaz pour un traitement au plasma selon la revendication 1, dans lequel l'élément de formation de tuyau d'alimentation est composé de titane ou de céramique.

3. Tuyau d'alimentation en gaz pour un traitement au plasma selon la revendication 1 ou 2, dans lequel le corps principal de tuyau d'alimentation comporte des trous de décharge de gaz.

4. Tuyau d'alimentation en gaz pour un traitement au plasma selon l'une quelconque des revendications 1 à 3, dans lequel le corps principal de tuyau d'alimentation est constitué d'un tube inoxydable poreux.

5. Tuyau d'alimentation en gaz pour un traitement au plasma selon l'une quelconque des revendications 1 à 4, dans lequel l'élément de connexion (12), le corps principal de tuyau d'alimentation (10) et l'élément d'extension de canal d'alimentation (11) présentent un coefficient de dilatation thermique de 10 x 10⁻⁶/°C, ou moins.

6. Tuyau d'alimentation en gaz pour un traitement au plasma selon la revendication 5, dans lequel l'élément d'extension de canal d'alimentation (11) est composé de céramique qui présente un coefficient de dilatation thermique de 7,0 x 10⁻⁶/°C ou moins, ou d'une fluororésine.

7. Tuyau d'alimentation en gaz pour un traitement au plasma selon l'une quelconque des revendications 1 à 6, dans lequel la longueur de la partie métallique du tuyau d'alimentation en gaz pour le traitement au plasma est fixée à la moitié de la longueur d'onde d'une micro-onde, et le canal d'alimentation en gaz s'étend jusque dans le voisinage de la partie inférieure du récipient en connectant l'élément d'extension de canal d'alimentation (11) au corps principal de tuyau d'alimentation (10) à travers l'élément de connexion (12).
